(19) Europäisches Patentamt

European Patent Office

Office européen des brevets

(11) Veröffentlichungsnummer: **0 201 869 B1**

(12) **EUROPÄISCHE PATENTSCHRIFT**

(45) Veröffentlichungstag der Patentschrift: **22.07.92**

(51) Int. Cl.⁵: $B41C\ 1/14$

(21) Anmeldenummer: **86106286.7**

(22) Anmeldetag: **07.05.86**

(54) **Siebdruckverfahren.**

(30) Priorität: **11.05.85 DE 3517011**

(43) Veröffentlichungstag der Anmeldung:
**20.11.86 Patentblatt  86/47**

(45) Bekanntmachung des Hinweises auf die
Patenterteilung:
**22.07.92 Patentblatt  92/30**

(84) Benannte Vertragsstaaten:
**DE FR GB IT NL**

(56) Entgegenhaltungen:
**DE-B- 1 154 327**
**GB-A- 912 168**
**US-A- 1 858 786**
**US-A- 3 158 077**
**US-A- 3 230 822**

(73) Patentinhaber: **Nokia (Deutschland) GmbH**
**Östliche Karl-Friedrich-Strasse 132**
**W-7530 Pforzheim(DE)**

(72) Erfinder: **Schlipf, Michael, Dr.**
**Epplerinweg 3**
**W-7060 Schorndorf(DE)**
Erfinder: **Tischer, Kurt Manfred**
**Gerhard-Hauptmann-Weg 4**
**W-7317 Wendlingen(DE)**
Erfinder: **Voigt, Klaus-Peter**
**Königsberger Strasse 10**
**W-7300 Esslingen(DE)**

**Beschreibung**

Die Erfindung bezieht sich auf ein Siebdruckverfahren.

Herkömmlich wird beim Siebdrucken zunächst auf einem von einem Rahmen umgebenen Sieb das gesamte Druckbild aufgebracht. Dieses Druckbild verschließt die Sieböffnungen in den Bereichen, die auf dem zu bedruckenden Material von Druckmaterial freigehalten werden sollen. Zur Negativabbildung eines Druckbildes auf dem mit Abstand unterhalb des Siebes und auf einer Trägerplatte ruhenden zu bedruckenden Materials wird sodann das Druckmaterial flächig auf dem Sieb aufgebracht. Hierbei benetzt das Druckmaterial all diejenigen Sieböffnungen, die nicht vom Druckbild verschlossen sind. Die Übertragung des die Sieböffnungen benetzenden Druckmaterials auf das zu bedruckende Material erfolgt dergestalt, daß das Sieb während des eigentlichen Druckvorgangs mittels einer oberhalb des Siebes angeordneten und in Längsrichtung des Siebes auf diesem verschiebbaren Rakel gegen das zu bedruckende Material gedehnt wird, indem die Rakel während ihrer Längsbewegung über das Sieb auf dieses gedrückt wird. Der Kontakt von Sieb und zu bedruckenden Material bewirkt, daß sich an der jeweiligen Kontaktstelle das Druckmaterial auf dem zu bedruckenden Material absetzt.

Dieses - in der Anmeldung als konventionell bezeichnete - Siebdruckverfahren hat den Nachteil, daß während des Druckvorganges das Sieb zwangsläufig gedehnt werden muß. Diese Dehnung bewirkt, daß die so erstellte Abbildung des Druckbildes auf dem zu bedruckenden Material immer von dem auf dem Sieb aufgebrachten Druckbild verschieden ist.

Zur Beseitigung dieses Nachteils wird in DE-A 2743234 eine Siebdruckmaschine angegeben, bei der sich in Ruhelage des Systems das Sieb ebenfalls etwas oberhalb des zu bedruckenden Materials befindet. Diese Anordnung - welche auch den Ausgangspunkt für die vorliegende Erfindung bildet - vermeidet die Verschiedenartigkeit in der Abbildung von Druckbild und Abbildung dadurch, daß das Sieb oder die Druckfläche (Trägerplatte) mit dem zu bedruckenden Material eine relative Bewegung erteilt wird, die der Bewegung der Rakel entgegengerichtet ist. Zur Synchronisierung der beiden zuvor angegebenen Bewegungen ist eine Mechanik notwendig, die die Siebdruckmaschine kompliziert.

Ferner ist in GB-A 912168 eine Anordnung bekannt, die sich mit der Verminderung von Verzerrungen zwischen der Druckvorlage und der letztlich erstellten Abbildung auf dem zu bedruckenden Material beim Rotationsdruck befaßt. Dieses Problem tritt beim Rotationsdruck dann auf, wenn entsprechend der planen Druckvorlage zunächst eine plane Druckplatte gefertigt wird und diese Druckplatte zur Montage auf der Druckwalze der Druckwalzenkontur angepaßt wird. Dieses Anpassen der Druckplatten an die Druckwalzen bewirkt nämlich, daß der äußere Umfang der Druckplatten gedehnt wird, so daß derartige Druckplatten nur noch eine gegenüber der planen Druckvorlage verzerrte Abbildung erlauben. Zur Behebung dieses Problems wird eine Vorrichtung vorgegeben, die die plane Druckvorlage so verzerrt, daß, wenn diese verzerrte, plane Druckvorlage um die Druckwalze gelegt wird, die sonst auftretenden und durch die Dehnung der planen und unverzerrten Druckplatte auftretenden Verzerrungen kompensiert werden. Die Verzerrung des Druckbildes wird dadurch erreicht, daß von dem Druckbild foto-optisch eine verzerrte Kopie angefertigt wird, indem in den Strahlengang ein zylindrisch gewölbter und dem Maß der Vorverzerrung entsprechender Spiegel eingesetzt wird.

Der Erfindung liegt die Aufgabe zugrunde, ein einfaches Siebdruckverfahren anzugeben, welches den durch die Dehnung des Siebes beim Drucken verursachten Fehler korrigiert.

Die Lösung dieser Aufgabe erfolgt mit den im Anspruch 1 angegebenen Mitteln. Eine vorteilhafte Ausgestaltung der Erfindung ist im Unteranspruch enthalten.

Die Erfindung wird nun anhand von einem in den Figuren gezeigten Ausführungsbeispiel näher erläutert. Es zeigt:

Fig. 1 schematisch eine Seitenansicht einer üblichen Druckvorrichtung in Ruhestellung;

Fig. 2 die Druckvorrichtung gemäß Fig. 1 in Arbeitsstellung und

Fig. 3 schematisch das Druckverfahren gemäß der Erfindung in einer Seitenansicht.

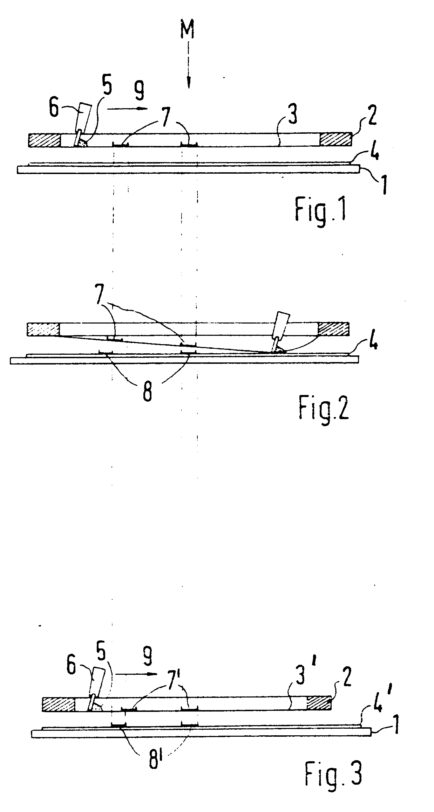

Die in Fig. 1 gezeigte bekannte Siebdruckvorrichtung weist eine Trägerplatte 1 und im beim Siebdrucken üblichen Abstand darüber einen Rahmen 2 mit dem darin eingespannten Sieb 3 auf. Der Rahmen 2 ist in den Figuren geschnitten dargestellt. Auf der Trägerplatte 1 liegt das zu bedruckende Material 4. Beim Druckvorgang wird die Rakel 6 in der eingezeichneten Richtung des Pfeiles 9 über das Sieb 3 gezogen und bringt dabei die Farbe 5 auf das zu bedruckende Material 4 entsprechend dem Druckbild 7 im Sieb 3. Der Einfachheit halber besteht in Fig. 1 das Druckbild 7 aus Quadraten an verschiedenen Stellen des Siebes 3. Die Mitte der Siebdruckvorrichtung ist durch den Pfeil M gekennzeichnet.

In Fig. 2 ist die Siebdruckvorrichtung fast am Ende des Druckvorganges dargestellt. Durch die Dehnung des Siebes 3 beim Siebdrucken sind die Quadrate des Druckbildes 7 versetzt und verzerrt auf dem zu bedruckenden Material 4 abgebildet worden. Diese Versetzungen und Verzerrungen sind an jedem Ort verschieden groß und in der Mitte des Siebes nicht vorhanden. Sie sind teilweise berechenbar. Auch quer zur Rakelbewegung erfolgt eine Versetzung und Verzerrung des Druckbildes 7.

Um nun das zu bedruckende Material 4 mit einem fehlerfreien Abbild 8 des Druckbildes im Sieb 3 zu erhalten, ist das Druckbild im Sieb entsprechend der Dehnung des Siebes beim Drucken vorzuverzerren.

In Fig. 3 ist die erfindungsgemäße Siebdruckvorrichtung mit einem entsprechend vorverzerrten Druckbild 7' im Sieb 3' dargestellt. Dabei sind die Quadrate des Druckbildes um die entsprechenden Beträge verschoben worden. Das dadurch auf dem zu bedruckenden Material 4' erzeugte Abbild ist mit 8' bezeichnet und liegt genau an der gewünschten Stelle.

In diesem Beispiel ist die Vorverzerrung des Druckbildes 7' im Sieb 3' entsprechend der Dehnung des Siebes beim Drucken in der Rakeldruckrichtung betrachtet worden. Zusätzlich muß auch eine derartige Vorverzerrung des Druckbildes in der Querrichtung berücksichtigt werden. Um die Berechnung der Vorverzerrungen des Druckbildes 3' zu umgehen, wird zunächst ein Probeabdruck eines Druckbildes 7 in konventioneller Siebdrucktechnik erstellt. Sodann werden anhand der Abbildung 8 und des Druckbildes 7 die auftretenden Fehler durch Ausmessung ermittelt. Anschließend wird dann auf einem neuen Sieb 3' ein entsprechend der gemessenen Fehler korrigiertes - vorverzerrtes - Druckbild 7' ausgebildet. Dieses Druckbild 7' wird dann zur Herstellung unverzerrter Abbildungen 8' auf dem zu bedruckenden Material 4' verwendet.

Das zu bedruckende Material 4' kann in einer oder mehreren nachfolgenden Behandlungen eine Deformation erfahren. Dabei kann sich die Abbildung 8' verändern. Auch diese Veränderungen können ausgemessen werden und zusätzlich bei der Vorverzerrung des Druckbildes im Sieb 3' berücksichtigt werden. Dazu ist es zweckmäßig, nach dem Probedruck mit einem unverzerrten Druckbild 7 erst die nachfolgenden Behandlungen auszuführen, bevor ein die Fehler ausschließendes Druckbild 7' erstellt wird.

**Patentansprüche**

1. Siebdruckverfahren,
   bei dem ein auf einem von einem Rahmen (2) umgebenen Sieb (3) ausgebildetes Druckbild (7) auf dem mit Abstand unterhalb des Siebes (3) angeordneten und auf einer Trägerplatte (1) liegenden zu bedruckenden Material (4) abgebildet wird, daß das Sieb (3), auf welches zuvor das Druckmaterial (5) flächig aufgebracht wurde, mittels einer oberhalb des Siebs (3) angeordneten und auf diesem verschiebbaren Rakel (6) gegen die Trägerplatte (1) gedehnt wird, wobei das Druckmaterial (5), auf das zu bedruckende Material (4) übertragen wird, **gekennzeichnet** durch folgende und in der zeitlichen Abfolge angegebene Schritte:
   1. Schritt:
   Ausbildung eines unverzerrten Druckbildes (7) auf dem Sieb (3);
   2. Schritt:
   Probeabdruck eines nach Schritt 1 erstellten Druckbildes (7) auf dem zu bedruckenden Material (4) mittels einer konventionellen Siebdruckanordnung;
   3. Schritt:
   Ermittlung der Abweichungen zwischen dem in Schritt 1 ausgebildeten Druckbild (7) und der in Schritt 2 erzeugten Abbildung (8);
   4. Schritt:
   Ausbildung eines Druckbildes (7') auf einem anderen Sieb (3'), wobei zur Beseitigung von Abbildungsfehlern dieses Druckbild (7') anhand der in Schritt 3 ermittelten Abweichungen in Längs- und Querrichtung vorverzerrt ist; und
   5. Schritt:
   Verwendung des in Schritt 4 erstellten Druckbildes (7') zu einer unverzerrten Abbildung (8') auf dem zu bedruckenden Material (4') in konventioneller Siebdrucktechnik.

2. Siebdruckverfahren nach Anspruch 1,
   **dadurch gekennzeichnet,**
   daß zwischen Schritt 2 und Schritt 3 Behandlungen des nach Schritt 2 bedruckten Materials (4) ausgeführt werden, die zu einer Deformation des mit der Abbildung (8) versehenen Materials (4) führen.

**Claims**

1. Screen printing process, in which an image carrier (7) formed on a screen (3) surrounded by a frame (2) is reproduced on the printing substrate (4), which is located at a distance beneath the screen (3) and lies on a support plate (1), in such a way that the screen (3), onto whose surface the printing material (5) has previously been applied, is stretched against the support plate (1) by means of a squeegee (6) arranged above the screen (3) and capable of being displaced on it, with the printing material (5) being transferred onto the printing substrate (4),
characterized by the following steps, indicated in their sequence of execution:

Step 1:

Formation of an undistorted image carrier (7) on the screen (3);

Step 2:

Test printing an image carrier (7) prepared in accordance with step 1 onto the printing substrate (4) by means of a conventional screen printing arrangement;

Step 3:

Determining the discrepancies between the image carrier (7) formed in accordance with Step 1, and the reproduction (8) generated in step 2;

Step 4:

Creation of an image carrier (7') on another screen (3'), with this image carrier (7') being dpredistorted in the lengthwise and transverse axes on the basis of the discrepancies determined in Step 3, in order to eliminate reproduction defects; and

Step 5:

Utilization of the image carrier (7') prepared in step 4 to produce an undistorted reproduction (8') on the printing substrate (4'), using a conventional screen printing technique.

2. Screen printing process according to Claim 1, characterised in that

treatments of the printing substrate (4) in accordance with step 2 which lead to a deformation of the substrate (4) bearing the reproduction (8), are performed between step 2 and step 3.

**Revendications**

1. Procédé sérigraphique par lequel une image-motif (7) appliquée sur un tamis (3) entouré d'un cadre (2) est reproduite sur le matériel à imprimer (4) disposé à une certaine distance en-dessous du tamis (3) et placé sur une plaque-support (1), le tamis (3) sur lequel a été appliqué au préalable en nappe le matériau d'impression (5) étant étendu moyennant une raclette (6) disposée au-dessus du tamis (3) et déplaçable sur ce dernier contre la plaque-support (1), le matériau d'impression (5) étant transmis ainsi sur le matériel à imprimer (4), **caractérisé** par les phases suivantes et dans l'ordre chronologique suivant:

1ère phase:

Application d'une image-motif (7) non distordue sur le tamis (3);

2ème phase:

Epreuve d'une image-motif (7) réalisée selon la phase 1 sur le matériel à imprimer (4) moyennant une disposition de sérigraphie classique;

3ème phase:

Détermination des déviations entre l'image-motif (7) appliquée dans la phase 1 et la reproduction (8) réalisée dans la phase 2;

4ème phase:

Application d'une image-motif (7') sur un autre tamis (3'), cette image (7') étant distordue dans le sens longitudinal et transversal à partir des déviations déterminées dans la phase 3;

5ème phase:

Utilisation de l'image-motif (7') réalisée dans la phase 4 pour une reproduction non distordue (8') sur le matériel à imprimer (4') dans la technique de sérigraphie classique.

2. Procédé sérigraphique selon la revendication 1, **caractérisé en ce que**

entre la phase 2 et la phase 3 le matériel imprimé (4) selon la phase 2 subit des traitements occasionnant une déformation du matériel (4) pourvu de l'image (8).

M

Fig.1

Fig.2

Fig.3